(19) Europäisches Patentamt / European Patent Office / Office européen des brevets

(11) **EP 4 624 622 A1**

(12) **EUROPEAN PATENT APPLICATION**

(43) Date of publication:
**01.10.2025 Bulletin 2025/40**

(21) Application number: **24167149.4**

(22) Date of filing: **28.03.2024**

(51) International Patent Classification (IPC):
**C23C 14/00** (2006.01)  **C23C 14/06** (2006.01)
**C23C 14/34** (2006.01)

(52) Cooperative Patent Classification (CPC):
**C23C 14/0036; C23C 14/0641; C23C 14/345;
C23C 14/3485; C23C 14/3492; C23C 28/044;
C23C 28/048; H01J 37/3467**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **WALTER AG**
**72072 Tübingen (DE)**

(72) Inventor: **Engelhart, Wolfgang**
**Tübingen (DE)**

(74) Representative: **Sandvik**
**Sandvik Intellectual Property AB
811 81 Sandviken (SE)**

(54) **CUTTING TOOL WITH TIALN-LAYER**

(57)     A coated cutting tool and a method for manufacturing the same, the cutting tool consisting of a substrate of cemented carbide, cermet, ceramics, steel, high speed steel or cubic boron nitride and a hard coating deposited thereon, wherein the coating comprises at least a (Ti,Al)N layer deposited by means of a High-Power Impulse Magnetron Sputtering (HIPIMS) process.

EP 4 624 622 A1

**Description**

**FIELD OF THE INVENTION**

The present invention relates to coated cutting tool consisting of a substrate and a hard coating deposited thereon, wherein the coating comprises at least a (Ti,Al)N layer deposited by a High-Power Impulse Magnetron Sputtering (HIPIMS) process. The present invention further relates to a method for manufacturing the coated cutting tool.

**BACKGROUND OF THE INVENTION**

Cutting tools, such as for example those used for the chip removing metal working, may consist of a substrate (base body) of cemented carbide, cermet, ceramics, steel, high speed steel or cubic boron nitride and a wear-resistant single-layer or multi-layer coating of hard metallic substances deposited thereon by means of CVD (chemical vapor deposition) or PVD (physical vapor deposition) processes. Among the PVD processes a distinction is made between different variants, for example cathode sputtering (sputter deposition), cathodic vacuum arc deposition (Arc PVD), ion plating, electron beam evaporation and laser ablation. Cathode sputtering, such as magnetron sputtering (MS), reactive magnetron sputtering and high-power impulse magnetron sputtering (HIPIMS), and the arc deposition are among the most frequently used PVD processes for the coating of cutting tools. Each type and variant of deposition processes has advantages and disadvantages over other processes with respect to the deposition process as such, but also with respect to the physical, chemical and/or mechanical properties of the deposited coatings.

Wear resistant CVD and PVD hard coatings of (Ti,Al)N on cutting tools are commercially available since the late 1980s. Tools coated with the metastable cubic-phase of (Ti,Al)N show excellent machining performance. Compared to TiN, TiC, Ti(C,N) and CrN, (Ti,Al)N coatings may have improved properties, such as better oxidation resistance and higher hardness, whereby the oxidation resistance has up to now been considered as a key factor for the superior mechanical properties and cutting performance of (Ti,Al)N coatings. It has been a general trend during recent years to increase the Al content in (Ti,Al)N coatings as it is assumed that a high Al content improves the properties of the coatings.

On one hand, it is known that, especially in Al-rich (Ti,Al)N coatings, secondary phase transformation and phase separation by spinodal decomposition take place at higher temperature conditions, going along with precipitation of hexagonal wurtzite-structure AlN, which is assumed to reduce the coating hardness and to lead to a molar volume mismatch within the (Ti,Al)N coating. On the other hand, it is assumed that the phase separation process involves the formation of nanometer-sized domains of cubic phase AlN in a cubic phase (Ti,Al)N matrix, and such domains that are coherent with the surrounding matrix have turned out to be beneficial in terms of retaining the hardness of the coating at higher temperatures. Thus, the secondary phase transformation in Al-rich (Ti,Al)N coatings appears to lead to an improvement in mechanical performance and wear resistance at elevated temperatures. Furthermore, it is assumed that a high Al content of the (Ti,Al)N coating promotes the formation of a protective outer $Al_2O_3$ layer during tool operation.

WO 2023/208597 A1 relates to a coated cutting tool comprising a substrate and a coating comprising a first, a second and a third layer, wherein the first layer is a (Ti, Al)N layer adhered to the substrate and having an atomic ratio Al/(Ti+Al) of 0.3 to 0.65, a fracture toughness ranging from 3.5 to 6 MPa m$^{1/2}$, and a substantially homogeneous residual stress in the range from +100 to -1000 MPa, the second layer is a (Ti, Al)N layer adhered to the first layer having an atomic ratio Al/(Ti+Al) of 0.3 to 0.85, a residual stress gradually increasing from the residual stress value at the interface with the first layer to the residual stress value at the interface with the third layer, and the third layer is composed of a nitride of one or more elements belonging to group 4, 5 or 6 of the periodic table of elements, or a nitride of Al and/or Si together with one or more elements belonging to group 4, 5 or 6 of the periodic table of elements, and said third layer has a substantially homogenous residual stress of less than -1200 MPa, preferably between -5000 MPa and -1500 MPa. The three-layered coating is made using cathodic arc deposition (Arc-PVD). In one embodiment the atomic ratio Al/(Al+Ti) of the second layer is 0.7 to 0.85. In another embodiment the atomic ratio Al/(Ti+Al) of the second layer gradually increases from the interface with the first layer to the interface with the third layer from 0.5 to 0.8 or from 0.55 to 0.75. In yet another embodiment the third layer is a (Ti,Al)N layer having an atomic ratio Al/(Ti+Al) ranging from 0.70 to 0.85.

WO 2013/068080 A1 describes a process for the production of a layer system by means of HIPIMS, whereby alternatingly longer and shorter pulse durations are applied. The obtained layer system is supposed to have good wear properties and considerable structural differences compared to layers deposited by DC-MS. Using the example of TiAlN coatings, the latter grow in DC-MS essentially in a columnar structure, whereas in the HIPIMS process a finer layer structure can achieved without integration of working gas ions into the layer due to the ionization of the evaporated metal. It is also described that a negative substrate bias in the HIPIMS process results in a higher density of the layers due to the high ion proportion in the sputtered material. The HIPIMS layers may be harder and denser than the coarse columnar DC-MS layers, but they also have disadvantages in terms of layer adhesion and mechanical properties.

Thus, with respect to the deposition process for wear resistant hard coatings, such as (Ti,Al)N coatings, each method exhibits advantages and disadvantages, which come into effect to a different extent depending on the type of tool and the field of application.

As an example, the cathodic arc deposition (Arc PVD), is characterized by a high deposition rate, dense layer structures due to a high ionization of the evaporated material, and good process stability. Furthermore, the high ionization of the metals in Arc-PVD results in a good bonding and adhesion of the deposited layer to the substrate or to the layer below. A substantial disadvantage, however, is the process-dependent deposition of micro particles (droplets) caused by the emission of small metal splashes, the avoidance of which is extremely complex. Droplet deposition is a problem especially with metals having a comparably low melting point, such as aluminum. The droplets lead to an undesirably high surface roughness on the deposited layers. In some applications, this in turn leads to an earlier wear of the tool due to increased adherence of the tool surface to the workpiece, increased friction forces and, as a result, increased cutting forces.

Layers deposited by means of DC-MS and HIPIMS often exhibit noticeable structural differences. DC-MS layers in general grow in a columnar structure on the material below. In the HIPIMS process, on the other hand, fine crystalline as well as granular crystalline layer structures can be achieved, which are characterized by an improved wear behavior of the layers as such, in comparison to DC-MS layers. HIPIMS layers are in general harder than the DC-MS layers, but also show disadvantages with regard to their adhesion to many materials. However, high adhesion of the coating is one of the key properties in order to avoid spalling of the coating and to obtain a long service live of the tool.

Reference to certain structures and/or methods in this background discussion should not be construed as an admission that such structures and/or methods constitute prior art. Applicant expressly reserves the right to show that certain structures and/or methods do not qualify as prior art.

## OBJECT OF THE INVENTION

It is an objective of the present invention to provide a coated cutting tool having a (Ti,Al)N coating with high wear resistance and fracture toughness and, at the same time, good coating-to-substrate adhesion in many machining operations and workpiece applications, including machining operations, wherein the cutting edges of the tool are exposed to a great load of heat and notch wear, such as in ISO-M machining.

It is a further object of the present invention to provide an economically feasible and sustainable method for manufacturing such a coated cutting tool.

## DESCRIPTION OF THE INVENTION

These objects are solved according to the invention by the method of independent claim 1 and the coated cutting tool of independent claim 8. Embodiments of the invention are defined by the dependent claims and the following description.

The present invention provides a method for manufacturing a coated cutting tool consisting of a substrate and a hard coating deposited thereon, the method comprising the deposition of at least a (Ti,Al)N layer onto a substrate of cemented carbide, cermet, ceramics, steel, high speed steel or cubic boron nitride by means of a High-Power Impulse Magnetron Sputtering (HIPIMS) process,

- wherein the deposition of the (Ti,Al)N layer comprises the three steps of:

  a) deposition of a (Ti,Al)N base layer (BL) from at least one target of Ti and Al having a stoichiometric ratio of Ti:Al of from 70:30 to 33:67 at a bias voltage within the range from 20 to 60 V for a time to deposit a base layer thickness of from 0.2 $\mu$m to 0.6 $\mu$m,

  b) deposition of a (Ti,Al)N gradient layer (GL) immediately onto the base layer (BL) from at least one target of Ti and Al having a stoichiometric ratio of Ti:Al of from 70:30 to 33:67 at a gradually increasing bias voltage from 20 to 60 V at the start of the deposition of the gradient layer (GL) to 80 to 150 V at the end of the deposition of the gradient layer (GL), for a time to deposit a gradient layer thickness of from 0.4 $\mu$m to 1.8 $\mu$m,

  c) deposition of a (Ti,Al)N top layer (TL) immediately onto the gradient layer (GL) from at least one target of Ti and Al having a stoichiometric ratio of Ti:Al of from 70:30 to 20:80 at a bias voltage within the range from 80 to 150 V for a time to deposit a top layer thickness of from 0.4 $\mu$m to 1.8 $\mu$m.

- wherein the depositions of the base layer (BL), the gradient layer (GL) and the top layer (TL) are carried out to a total thickness of the (Ti,Al)N layer of not more than 4.0 $\mu$m.

If not otherwise explicitly stated, the positive values of bias voltage in the HIPIMS process mean the substrate bias voltage, which in many publications are also indicated as negative values using a minus sign ("-"). The term "stoichiometric" ratio of Ti:Al means "atomic" ratio or "molar" ratio.

The present invention further provides a coated cutting tool consisting of a substrate of cemented carbide, cermet, ceramics, steel, high speed steel or cubic boron nitride and a hard coating deposited on the substrate, wherein the coating comprises at least a (Ti,Al)N layer deposited by a High-Power Impulse Magnetron Sputtering (HIPIMS) process and having a thickness of at least 1.0 μm and not more than 4.0 μm, wherein

- the (Ti,Al)N layer comprises

   a) a (Ti,Al)N base layer (BL) having a base layer thickness of from 0.2 μm to 0.6 μm,
   b) a (Ti,Al)N gradient layer (GL) immediately on top of the base layer (BL) having a gradient layer thickness of from 0.4 μm to 1.8 μm,
   c) a (Ti,Al)N top layer (TL) immediately on top of the gradient layer (GL) having a top layer thickness of from 0.4 μm to 1.8 μm.

- wherein each of the base layer (BL) and the gradient layer (GL) has a stoichiometric ratio of Ti:Al of from 70:30 to 33:67, and wherein the top layer (TL) has a stoichiometric ratio of Ti:Al of from 70:30 to 20:80, and
- wherein the crystallite size within the base layer (BL) of the (Ti,Al)N layer is at least three times the crystallite size within the gradient layer (GL) of the (Ti,Al)N layer, when the crystallite size is determined by XRD line profile analysis (XLPA) applying grazing Incidence XRD (GIXRD).

The present invention provides a coated cutting tool and a method for producing a coated cutting tool with a (Ti,Al)N layer of high wear resistance, fracture toughness and a good coating-to-substrate adhesion in a variety of machining operations and workpiece applications, including those, wherein the cutting edges of the tool are exposed to a great load of heat and notch wear, such as in ISO-M machining. Compared to known Al-rich (Ti,Al)N coatings the formation of weakening hexagonal AlN phase due to secondary phase transformation and phase separation by spinodal decomposition is reduced, and, at the same time, the high performance of the coating is comparable to Al-rich (Ti,Al)N coatings.

In an embodiment of the method of the present invention the deposition of the (Ti,Al)N top layer (TL) immediately onto the gradient layer (GL) is carried out from at least one target of Ti and Al having a stoichiometric ratio of Ti:Al of from 70:30 to 33:67.

In another embodiment of the method of the present invention the depositions of the base layer (BL), the gradient layer (GL) and the top layer (TL) are carried out from one or more targets of the same type, i. e. from targets having the same or at least very similar stoichiometric ratio of Ti:Al of from 70:30 to 33:67.

Thus, the method of the present invention may further provide benefits with respect to sustainability and economy in the process, since no targets (cathodes) of different Ti:Al ratios are required within the deposition equipment, such as targets with high, medium and low Al contents. This allows for using more targets of the same type at the same time, which in turn reduces the required heating power and the process time for the deposition of the coating of the present invention.

The depositions of the base layer (BL), the gradient layer (GL) and the top layer (TL) are carried out to a total thickness of the (Ti,Al)N layer of not more than 4.0 μm. If the total thickness of the (Ti,Al)N layer is higher than 4.0 μm, a shortened tool life has been observed due to early flaking and delamination of the coating during machining operation.

The (Ti,Al)N layer deposited in the HIPIMS process of the present invention shows superior adherence to the substrate and, at the same time, excellent machining properties of the coating, such as high hardness and a high modulus of elasticity (Young's modulus), beneficial for a wide variety of machining operations. Furthermore, the layer has a low surface roughness, which is beneficial to reduce friction forces between the tool and the workpiece, and thus, to reduce cutting forces. Without being bound to theory, it is assumed that the superior adherence to the substrate is conveyed by the type and deposition conditions of the base layer (BL), and the excellent machining properties are the result of a change of the microstructure, especially the crystallite size, and the residual stress within the coating due to the type and deposition conditions of the gradient layer (GL) towards the top layer (TL).

The deposition of the (Ti,Al)N base layer (BL) in the HIPIMS process is carried out at a bias voltage within the range from 20 to 60 V. Applying a bias voltage within this range is assumed to provide superior adherence of the (Ti,Al)N layer to the substrate or to a layer underneath the base layer (BL) and to be effective to improve the tool life. If the bias voltage is less than 20 V the density of the layer is not satisfying, voids within the layer may occur and the residual stress level may disadvantageously be in the regions of tensile stress. If the bias voltage is higher than 60 V the adherence to the substrate or to a layer underneath the (Ti,Al)N base layer (BL) may be impaired due to high compressive stress levels within the layer, which might lead to flaking of the coating.

The (Ti,Al)N base layer (BL) of the inventive coated cutting tool has a layer thickness within the range from 0.2 μm to 0.6 μm, and the deposition of the (Ti,Al)N base layer (BL) in the HIPIMS process is carried out for a time to deposit a base layer within this thickness range. If the base layer thickness is less than 0.2 μm the adherence improving effect of the (Ti,Al)N base layer may be impaired. It is assumed that this is caused by the development of a too large residual stress difference or gradient, respectively, between the base layer (BL) and the substrate or layer underneath. A base layer thickness higher

than 0.6 μm is not required and not desired as it does not further contribute to the adherence improving effect of the (Ti,Al)N base layer, on one hand, and it would without need contribute to the total thickness of the (Ti,Al)N layer, which in turn would reduce the thickness options for the depositions of the (Ti,Al)N gradient and top layers within the (Ti,Al)N layer total thickness limits. As stated, if the total thickness of the (Ti,Al)N layer is higher than 4.0 μm, a shortened tool life has been observed due to early flaking and delamination of the coating during machining operation.

The deposition of a (Ti,Al)N gradient layer (GL) immediately onto the base layer (BL) is carried out at a gradually increasing bias voltage from 20 to 60 V at the start of the deposition of the gradient layer (GL) to 80 to 150 V at the end of the deposition of the gradient layer (GL).

Herein, the term "gradually increasing" or "gradually decreasing" means an increase or a decrease, respectively, from a starting-condition towards an end-condition. In an embodiment of the invention, "gradually" means a continuous and steady increase or decrease, respectively, such that "gradually increasing" excludes an intermediate decrease on the path from a starting-condition towards an end-condition, and "gradually decreasing" excludes an intermediate increase on the path from a starting-condition towards an end-condition. In an embodiment of the invention, "gradually" means a continuous linear increase or decrease from a starting-condition to an end-condition. However, "gradually" may also describe a stepwise increase or decrease from a starting-condition towards an end-condition.

The gradual increase of the bias voltage during the deposition of the gradient layer (GL) leads to a change of the coating layer characteristics within the (Ti,Al)N gradient layer (GL) compared to the characteristics within the (Ti,Al)N base layer (BL) at least with respect to the crystallite size. The crystallite size within the base layer (BL) is comparably large, and it decreases within the (Ti,Al)N gradient layer (GL), which is in the method of the present invention due to the gradually increasing bias voltage from the start to the end of the deposition of the (Ti,Al)N gradient layer (GL). In an embodiment of the invention the crystallite size within the (Ti,Al)N top layer (TL) is essentially equal to the crystallite size achieved at the end of the deposition of the (Ti,Al)N gradient layer (GL).

The (Ti,Al)N gradient layer (GL) of the inventive coated cutting tool has a layer thickness within the range from 0.4 μm to 1.8 μm, and the deposition of the (Ti,Al)N gradient layer (GL) in the HIPIMS process is carried out for a time to deposit a base layer within this thickness range. If the gradient layer thickness is less than 0.4 μm, the beneficial effect of the gradient layer (GL) may not be achieved. A gradient layer thickness higher than 1.8 μm is not required and not desired as it does not further improve the beneficial effect of the (Ti,Al)N gradient layer (GL), on one hand, and it would without need contribute to the total thickness of the (Ti,Al)N layer, which in turn would reduce the thickness options for the depositions of the (Ti,Al)N base and top layers within the (Ti,Al)N layer total thickness limits.

The deposition of the (Ti,Al)N top layer (TL) immediately onto the gradient layer (GL) is carried out at a bias voltage within the range from 80 to 150 V for a time to deposit a top layer thickness of from 0.4 μm to 1.8 μm. In an embodiment of the invention the (Ti,Al)N top layer (TL) essentially continues the layer characteristics achieved at the end of the deposition of the (Ti,Al)N gradient layer (GL) and contributes to the high wear resistance, hardness and toughness of the entire (Ti,Al)N layer.

A top layer thickness higher than 1.8 μm is not required and not desired as it does not further improve the beneficial effect of this layer, on one hand, and it would without need contribute to the total thickness of the (Ti,Al)N layer, which in turn would reduce the thickness options for the depositions of the (Ti,Al)N base and gradient layers within the (Ti,Al)N layer total thickness limits.

According to the present invention the crystallite size within the base layer (BL) of the (Ti,Al)N layer is at least three times the crystallite size within the gradient layer (GL) of the (Ti,Al)N layer, when measured at the end of the deposition of the gradient layer (GL), whereby for the purpose of the present invention crystallite size is indicated and measured as the arithmetic-weighted mean crystallite diameter determined by XRD line profile analysis (XLPA) applying grazing incidence XRD (GIXRD), as described below. If the difference of the crystallite size within the base layer (BL) and the gradient layer (GL) is smaller, the advantageous properties of superior adherence and excellent machining properties of the (Ti,Al)N layer in terms of wear resistance, hardness and toughness may not concurrently be achieved and either one of these advantages may not be reached to the desired extent.

In an embodiment of the present invention the crystallite size within the base layer (BL) of the (Ti,Al)N layer is about 300 to 500 nm, and the crystallite size within the gradient layer (GL) of the (Ti,Al)N layer, when measured at the end of the deposition of the gradient layer (GL), is about 50 to 100 nm. In an embodiment of the present invention the crystallite size within the top layer (TL) of the (Ti,Al)N layer is about 50 to 100 nm. In another embodiment of the present invention the crystallite size within the top layer (TL) of the (Ti,Al)N layer is about 5 to 40 nm, which may be achieved with a high Al content in the top layer (TL), such as a stoichiometric ratio of Ti:Al of about 30:70 to 20:80.

According to an embodiment of the method of the present invention, the deposition of the gradient layer (GL) is carried out at a steadily increasing gradient of the bias voltage, preferably a linearly increasing gradient of the bias voltage, from a start value of the bias voltage at the start of the deposition of the gradient layer (GL) to an end value of the bias voltage at the end of the deposition of the gradient layer (GL).

In an alternative embodiment of the method of the present invention, the deposition of the gradient layer (GL) is carried out by step-wise increasing the bias voltage, wherein preferably small step widths within a range of 1 to 10 Volts per increase step are applied and/or each bias voltage step is preferably held for the same or essentially the same holding time interval. In an embodiment of the deposition of the gradient layer (GL) by step-wise increasing the bias voltage, the number of bias voltage increasing steps from a start bias voltage to an end bias voltage is within the range from 5 to 40 steps or from 10 to 30 steps at preferably the same step-widths and/or the same holding time intervals for each step.

According to another embodiment of the method of the present invention, the deposition of the base layer (BL) is carried out at a constant bias voltage within the range from 20 to 60 V.

Additionally, or in another embodiment, the deposition of the gradient layer (GL) starts at the bias voltage applied at the end of the deposition of the base layer (BL).

Further additionally or in another embodiment, the deposition of the top layer (TL) is carried out at a constant bias voltage within the range from 80 to 150 V, preferably at the bias voltage applied at the end of the deposition of the gradient layer (GL).

According to another embodiment of the method of the present invention, the depositions of the base layer (BL), the gradient layer (GL) and the top layer (TL) are carried out to a total thickness of the (Ti,Al)N layer of from 1.0 $\mu$m to 4.0 $\mu$m or from 1.2 $\mu$m to 3.5 $\mu$m or from 1.5 $\mu$m to 3.2 $\mu$m.

Additionally or in another embodiment, the deposition of the base layer (BL) is carried out for a time to deposit a base layer thickness of from 0.3 $\mu$m to 0.6 $\mu$m or from 0.4 $\mu$m to 0.5 $\mu$m.

Additionally or in another embodiment, the deposition of the gradient layer (GL) is carried out for a time to deposit a gradient layer thickness of from 0.6 $\mu$m to 1.6 $\mu$m or from 0.8 $\mu$m to 1.4 $\mu$m.

Additionally or in another embodiment, the deposition of the top layer (TL) is carried out for a time to deposit a top layer thickness of from 0.6 $\mu$m to 1.6 $\mu$m or from 0.8 $\mu$m to 1.4 $\mu$m.

According to another embodiment of the method of the present invention, the deposition of the gradient layer (GL) is carried out for a time to deposit a gradient layer thickness that is at least 1.5 times the thickness of the base layer (BL) or at least 1.8 times the thickness of the base layer (BL) or at least 2.0 times the thickness of the base layer (BL).

According to another embodiment of the method of the present invention,

the deposition of the base layer (BL) is carried out at

- a sputter power within the range from 25 kW to 50 kW,
- a temperature within the range from 400°C to 500°C,
- an $N_2$ pressure within the range from 0.45 Pa to 0.70 Pa,
- an Ar pressure within the range from 0.30 to 0.80 Pa,

wherein the sputter power, the temperature, the $N_2$ pressure and/or the Ar pressure are pref-erably kept constant during the deposition of the (Ti,Al)N base layer (BL).

Additionally or in another embodiment, the deposition of the gradient layer (GL)

- is started at the values of the sputter power, the temperature, the $N_2$ pressure and the Ar pressure within the same ranges as defined for the base layer (BL) or at the same values as applied at the end of the deposition of the base layer (BL), and
- is continued until the end of the deposition of the gradient layer (GL) at the values of the sputter power, the temperature, the $N_2$ pressure and the Ar pressure within the same ranges as defined for the base layer (BL) or at the same values as applied at the end of the deposition of the base layer (BL), or
- is continued until the end of the deposition of the gradient layer (GL)

  - by gradually increasing the sputter power to 1.5 to 2.5 times of the sputter power at the start of the deposition of the gradient layer (GL), and/or
  - by gradually decreasing the temperature to a temperature 30°C to 150°C or 50°C to 120°C or 60°C to 100°C below the temperature at the start of the deposition of the gradient layer (GL), and/or
  - by gradually increasing the $N_2$ pressure to 1.1 to 1.5 times of the $N_2$ pressure at the start of the deposition of the gradient layer (GL).

Additionally or in another embodiment, the deposition of the (Ti,Al)N top layer (TL) is carried out at the values of the sputter power, the temperature, the $N_2$ pressure and the Ar pressure within the same ranges as defined for the base layer (BL) or at the same values as applied at the end of the deposition of the gradient layer (GL), wherein the sputter power, the temperature, the $N_2$ pressure and/or the Ar pressure are preferably kept constant during the deposition of the (Ti,Al)N top layer (TL).

According to another embodiment of the method of the present invention, and accordingly, to an embodiment of the coated cutting tool of the present invention, the base layer (BL) is deposited immediately onto the substrate surface.

In an alternative embodiment, an intermediate layer is deposited immediately onto the substrate surface prior to the deposition of the base layer (BL), and the base layer (BL) is deposited onto the intermediate layer, wherein the intermediate layer is preferably selected from TiN, TiC and TiCN and has a thickness of from 0.2 μm to 0.8 μm.

According to an embodiment of the coated cutting tool of the present invention, the crystallite size within the base layer (BL) of the (Ti,Al)N layer is at least three times, preferably at least four times or at least five times the crystallite size within the top layer (TL) of the (Ti,Al)N layer, when the crystallite size is determined by XRD line profile analysis (XLPA) applying grazing Incidence XRD (GIXRD).

According to another embodiment of the coated cutting tool of the present invention, the residual stress of the (Ti,Al)N layer is less than -5.000 MPa, or less than -6.000 MPa or less than -7.000 MPa (= compressive stress), when the residual stress is determined by XRD measurement and applying the $\sin^2\psi$-method using the {111}-reflection of cubic TiAlN.

According to another embodiment of the coated cutting tool of the present invention, the (Ti, Al)N layer is characterized by a normalized peak intensity ratio

$$\left[\frac{I(1\ 1\ 1)}{I_0(1\ 1\ 1)}\right] / \left[\frac{I(2\ 0\ 0)}{I_0(2\ 0\ 0)}\right]$$

in the XRD of larger than 3, preferably larger than 4 or larger than 5, wherein

$I(1\ 1\ 1)$ and $I(2\ 0\ 0) =$     measured intensities of the (1 1 1) and (2 0 0) hkl-reflections in the XRD of the (Ti,Al)N layer,

$I_0(1\ 1\ 1)$ and $I_0(2\ 0\ 0) =$     standard intensities of the (1 1 1) and (2 0 0) hkl-reflections of the standard powder diffraction data according to JCPDF-card no. 00-038-1420.

According to another embodiment of the coated cutting tool of the present invention, the (Ti,Al)N layer consists of cubic phase (Ti,Al)N, determined by XRD.

According to another embodiment of the coated cutting tool of the present invention, the (Ti, Al)N layer has a Vickers hardness HV0.015 ≥ 3200, preferably ≥ 3300, more preferably ≥ 3400.

According to another embodiment of the coated cutting tool of the present invention, the (Ti, Al)N layer has a reduced Young's modulus of > 470 GPa, preferably > 480 GPa, more preferably > 490 GPa.

The coated cutting tool of the present invention is producible or produced according to the method of the present invention, as defined and described herein.

It is understood that herein (Ti,Al)N may also be written as and be defined by the general formula $Ti_xAl_{(1-x)}N_y$, with x, (1-x), and y being the stoichiometric amounts of Ti, Al and N, respectively. A stoichiometric ratio of Ti:Al of from 70:30 to 33:67, means 0.70 ≥x≥0.33 and 0.30 ≤(1-x)≤ 0.67. In an embodiment of the present invention, N is present in the (Ti,Al)N layer in an stoichiometric amount, i. e. y = 1, however, N may also be present in the (Ti,Al)N layer in a slightly under-stoichiometric amount or over-stoichiometric amount relative to the stoichiometric amounts of Ti+Al with y being with the range of 0.85 ≤y≤ 1.15 or 0.90 ≤y≤ 1.10 or 0.95 ≤y≤ 1.05.

In an embodiment of the coated cutting tool of the present invention, each of the base layer (BL), the gradient layer (GL) and the top layer (TL) has a stoichiometric ratio of Ti:Al of from 65:35 to 35:65 or from 60:40 to 40:60 or from 55:45 to 45:55. A lower Al content within the (Ti,Al)N layer reduces the danger of spinodal decomposition and the formation of undesired hexagonal AlN phase, especially in machining operations, wherein the cutting tool is exposed to a great load of heat.

It is understood that in the method according to the present invention, the target compositions for the deposition of the (Ti,Al)N layer, i. e. the amounts and the ratio of Ti and Al in the targets, are selected according to the desired ratio of Ti:Al within the deposited (Ti,Al)N layer considering the applied deposition conditions.

According to an embodiment of the invention, the surface of the top layer (TL) of the (Ti,Al)N layer has an average surface roughness Ra, measured over a length of 4.8 mm of ≤0.12 μm, preferably ≤0.06 μm.

In an embodiment of the present invention, the (Ti,Al)N layer is the only layer or the outermost layer of the coated cutting tool of the present invention with the top layer (TL) of the (Ti,Al)N layer being exposed to the outermost surface of the tool.

However, it is understood that in another embodiment of the present invention, one or more additional wear-resistant and/or decorative covering coatings may be deposited on top of the (Ti,Al)N layer. For example, a thin decorative covering layer of TiN or ZrN of preferably less than 0.8 μm, such as in the range from about 0.05 to 0.5 μm, may be deposited as an outermost layer on top of the (Ti,Al)N layer. Such covering layers are known and may be advantageous to indicate whether or not a tool has already been used or to indicate the degree of wear at the regions of contact between the tool and the workpiece. Furthermore, the provision of a covering layer may have tribochemical advantages. For example, a ZrN covering layer is known to have tribochemical advantages in machining in particular of titanium alloys being used, for example, in the aerospace industry and in machining of stainless steels.

According to an embodiment of the present invention, the substrate of the cutting tool consists of cemented carbide (hard metal). A suitable cemented carbide substrate comprises 5 to 14 wt-% Co binder, 0 to 3.0 wt-% of cubic carbides, preferably cubic carbides selected from TiC, TaC and NbC, and balance WC. According to an embodiment of the cemented carbide substrate, the WC has an average grain size of 0.5 to 5 $\mu$m, preferably an average grain size of 1.0 to 3.0 $\mu$m, particularly preferably an average grain size of 1.0 to 2.0 $\mu$m. Cemented carbides with grain sizes of WC in the afore-mentioned range are also referred to as fine grain grades. Such a fine grain grade in combination with a high content of Co binder, such as 9 to 14 wt-% Co binder, provides a tool substrate with high hardness and toughness, which is particularly advantageous for the machining of ISO P workpieces characterize according to ISO 513 (unalloyed and alloyed steel, cast steel, stainless ferritic and martensitic steel, long chipping malleable iron) and ISO M workpieces (stainless steels, cast steel, manganese steel, alloyed gray iron, stainless austenitic steel, cast malleable iron, free-cutting steel).

In an embodiment of the present invention the coated cutting tool is designed as a milling tool, preferably an end milling tool, particularly preferably a face milling cutter. In milling, in particular in end milling and face milling, the cutting tool according to the invention is of particularly advantage as these applications require particularly low surface roughness of the tool and high layer bonding, which the cutting tool according to the invention fulfills.

## DEFINITIONS and METHODS

### Crystallite Size Determination by X-ray Line Profile Analysis (XLPA)

The X-ray diffraction patterns concerning the phase analysis were acquired by Grazing Incidence Mode (GIXRD) on a diffractometer from Panalytical (Empyrean). CuK$\alpha$-radiation with line focus was used for the analysis (high tension 40 kV, current 40 mA). The incident beam was defined by a 2 mm mask and a 1/8° divergence slit in addition with a X-ray mirror producing a parallel X-ray beam. The sideways divergence was controlled by a Soller slit (0.04°). For the diffracted beam path a 0.18° parallel plate collimator in conjunction with a proportional counter (0D-detector) was used. The measurement was done in grazing incidence mode (Omega = 1°). The 2-Theta range was about 28° to 70° with a step size of 0.05° and a counting time of 7 s. For the XRD line-profile analysis (XLPA) a reference measurement (with LaB$_6$ powder) was done with the instrumental settings as described above to correct for the instrumental broadening.

The evaluation of the coherent diffracting domains, corresponding to the crystallite size, was done by XRD line-profile analysis (XLPA) according to the single line method. The peak profile was fitted by Pseudo-Voigt function and the size-strain analysis was done by separating the peak profile into a Gauss-part and a Lorentz-part (gaussian peak broadening: strain effect; Lorentzian peak broadening: size effect). The peak fitting procedure was done by software package HighScore 5.1a from company Malvern Panalytical B.V., Almelo, The Netherlands.

For grazing incidence XRD measurements to determine coherent diffracting domains or crystallite size, respectively, of a layer of a coating having further deposited layers above itself and/or at different depths within a certain layer of a coating, such as in the base layer (BL), the gradient layer (GL) or the top layer (TL) of the (Ti,Al)N layer, one option is to remove coating material until the layer or depth of a layer to be measured is exposed to the outer surface of the sample. Care has to be taken to select and apply a method for the removal of material which does not significantly alter the material properties within the remaining layer material. For the measurements according to the present invention, for the removal of deposited coating material gentle and slow polishing using a fine-grained polishing agent was applied. Other suitable methods for the removal of deposited coating material are ion etching and laser ablation. Another option, also suitable for the measurements according to the present invention, is to carry out depositions on several samples under the same conditions and to stop the depositions or remove samples from the reactor after different deposition times, i. e. at different deposition thicknesses, to carry out the measurements at different depths or thicknesses, respectively.

### Residual stress measurement

For the analysis of the residual stresses in the coatings of the present invention and of reference coating a diffractometer from Seifert / GE (PTS 3003) was used. CuK$\alpha$-radiation with a polycapillary lens (for producing a parallel beam) was applied for the analysis (high tension 40 kV, current 40 mA). The incident beam was defined by a 2 mm pinhole. For the diffracted beam path an energy dispersive detector (Meteor 0D) was used. X-ray stress analysis was carried out according to the sin$^2\psi$-method. For the stress evaluation the {111}-reflection of cubic TiAlN was used with the X-ray elastic constants of $s_1$ = -4,910 $\cdot 10^{-7}$ MPa$^{-1}$ and $0.5s_2$ = 2,780 $\cdot 10^{-6}$ MPa$^{-1}$. The stresses were measured applying the chi-mode tilting the chi-axis from -60° to 60° with equidistant intervals in sin$^2\psi$ (15 steps in chi-angles). XRD measurements for determination of normalized peak intensity ratio, as defined herein, were carried out accordingly. The peak fitting was done by applying Rachinger correction (to correct for K$\alpha$2) and a pseudo Voigt function to perform peak fitting.

For measurements of residual stress of a layer of a coating having further deposited layers above itself and/or at different depths within a certain layer of a coating, the same options apply as described above for the grazing incidence measurements.

Hardness and Young's modulus measurements

The measurements of hardness and Young's modulus (= reduced Young's modulus) were performed on the flank face of the coated tools by the nanoindentation method on a Fischer-scope® HM500 Picodentor (Helmut Fischer GmbH, Sindelfingen, DE) applying the Oliver and Pharr evaluation algorithm, wherein a diamond test body according to Vickers was pressed into the layer and the force-path curve was recorded during the measurement. The maximum load used was 15 mN and the time period for load increase and load decrease was 20 seconds each. From this curve hardness (HV 0.0015) and (reduced) Young's modulus were calculated.

Scanning Electron Microscopy (SEM)

The morphology of the coatings was studied by scanning electron microscopy (SEM) using a Supra 40 VP (Carl Zeiss Microscopy GmbH, Jena, Germany). Cross sections were characterized with the SE2 (Everhart-Thornley) Detector.

Thickness determination

The thickness of a layer was determined by scanning electron microscopy (SEM) on a cross-section of the coating. Since the layers or transitions between layers within the (Ti,Al)N layer (boundaries from base layer (BL) to gradient layer (GL) and from gradient layer (GL) to top layer (TL)) may be difficult to distinguish in SEM, the thickness measurements can be done on several samples treated under the same conditions, but removed from the reactor after the deposition of a certain layer.

Surface roughness measurement

The surface roughness is measured with a roughness measuring device P800 type measuring system of the manufacturer JENOPTIK Industrial Metrology Germany GmbH (formerly Hommel-Etamic GmbH) using the evaluation software TURBO WAVE V7.32, determining the waviness according to ISO 11562, TKU300 sensing device and KE590GD test tip with a scan length of 4.8 mm and measured at a speed of 0.5 mm/ s.

Sample preparation and PVD equipment

The HIPIMS coatings were produced in a 6-flange PVD installation INGENIA S3p (Oerlikon Balzers Coating AG, Balzers, Liechtenstein). The substrates were rotated on rotating tables. For the HIPIMS process, a plasma generator from Oerlikon Balzers was used. Prior to the deposition, the substrate bodies were pretreated by ultrasonic cleaning in ethanol and plasma cleaning. The PVD reactor was evacuated to $8 \times 10^{-5}$ mbar, and the substrate bodies were pretreated at 550°C. The depositions were run in an $Ar + N_2$ atmosphere, whereby the Ar partial pressure was set and the $N_2$ partial pressure was controlled. The depositions of each layer were carried out from three targets of the same type and composition.

**Examples**

Inventive and comparative HIPIMS (Ti,Al)N coatings were prepared on cemented carbide substrates of a WC fine grain grade having 12 wt-% Co.

The HIPIMS average total cathode power during deposition was 10 kW corresponding to about 6.25 W/cm$^2$ of the target. The remaining deposition parameters are indicated in the tables below. The values given are average values since the plasma conditions change constantly as the substrate table is moved.

Example 1 (Invention)

| | Base Layer (BL) | Gradient Layer (GL) | Top Layer (TL) |
|---|---|---|---|
| **Target (active)** | Ti:Al (40:60) | Ti:Al (40:60) | Ti:Al (40:60) |
| **$T_{on}$ [ms]** | 3.76 | 3.76 | 3.76 |

(continued)

|  | Base Layer (BL) | Gradient Layer (GL) | Top Layer (TL) |
|---|---|---|---|
| $T_{del}$ [ms] | 0.01 | 0.01 | 0.01 |
| Sputter Power [kW] (total) | 32 | 32 → 60 | 60 |
| Sputter Power [kW] (average per target) | 4.8 | 4.8 → 9.0 | 9.0 |
| Repetitions | 2 | 2 | 2 |
| Ar [Pa] | 0.43 | 0.43 | 0.43 |
| $N_2$ [Pa] | 0.59 | 0.56 → 0.60 | 0.60 |
| Bias Voltage [-V] | 40 | 40 → 120 (linear) | 120 |
| Temperature [°C] | 430 | 430 → 350 (linear) | 350 |
| Duration [min] | 7 | 60 | 60 |
| Thickness [μm] | ~ 0.45 | ~ 1.20 | ~ 1.20 |
| ($T_{on}$ = duration of a single pulse; $T_{del}$ = overlap time between the end of a pulse and the beginning of the following pulse at another target; Sputter Power = power the pulse unit receives; Duration = overall duration of the coating of the individual layer) | | | |

Example 2 (Invention)

Example 2 was prepared as example 1, except that the temperature during the deposition of the gradient layer (GL) was held constant at 430°C.

Example 3 (Invention)

|  | Base Layer (BL) | Gradient Layer (GL) | Top Layer (TL) |
|---|---|---|---|
| Target (active) | Ti:Al (40:60) | Ti:Al (40:60) | Ti:Al (27:73) |
| $T_{on}$ [ms] | 3.76 | 3.76 | 1.955 |
| $T_{del}$ [ms] | 0.01 | 0.01 | 0.01 |
| Sputter Power [kW] (total) | 32 | 32 → 60 | 60 |
| Sputter Power [kW] (average per target) | 4.8 | 9.0 | 7.0 |
| Repetitions | 3 | 3 | 3 |
| Ar [Pa] | 0.43 | 0.43 | 0.43 |
| $N_2$ [Pa] | 0.59 | 0.56 → 0.60 | 0.66 (10 min.) 0.63 (77 min.) |
| Bias Voltage [-V] | 40 | 40 → 120 (linear) | 120 |
| Temperature [°C] | 430 | 430 → 350 (linear) | 350 |
| Duration [min] | 7 | 60 | 10 + 77 |
| Thickness [μm] | ~ 0.45 | ~ 0.70 | ~ 1.40 |

Example 4 (Comparative)

| | Layer 1 | Layer 2 |
|---|---|---|
| Target (active) | Ti:Al (40:60) | Ti:Al (40:60) |
| $T_{on}$ [ms] | 7.56 | 7.56 |
| $T_{del}$ [ms] | 0.01 | 0.01 |
| Sputter Power [kW] (total) | 60 | 60 |
| Sputter Power [kW] (average per target) | 9.0 | 9.0 |
| Repetitions | 1 | 1 |
| Ar [Pa] | 0.43 | 0.43 |
| $N_2$ [Pa] | 0.20 | 0.17 |
| Bias Voltage [-V] | 40 | 40 |
| Temperature [°C] | 430 | 430 |
| Duration [min] | 16 | 180 |
| Thickness [μm] | ~ 0.10 | ~ 1.75 |

The crystallite sizes (= sizes of coherently diffracting domains) were determined as described above. The crystallite sizes of the base layers (BL) of inventive examples 1, 2 and 3, as well as of layers 1 and 2 of the comparative example 4 were in the order of about 380 nm $\pm$ 60 nm. In the inventive examples 1, 2 and 3, the crystallite sizes decreased within the gradient layer (GL) down to about 55 nm $\pm$ 20 nm. In the inventive examples 1 and 2, wherein the top layers (TL) were deposited from Ti:Al (40:60) targets, the crystallite sizes in the top layer (TL) were about the same as at the end of the gradient layer deposition, i. e. about 55 nm $\pm$ 20 nm. In the inventive example 3, wherein the top layer (TL) was deposited from high-Al Ti Al (27:73) targets, the crystallite size in the top layer (TL) was even much smaller in the order of about 15 nm $\pm$ 5 nm.

Mechanical Properties

| Example | | Young's Modulus [GPa] | Hardness [Vickers] | Residual Stress [MPa] |
|---|---|---|---|---|
| 1 | (INV) | 494 | 3456 | -7424 $\pm$ 124 |
| 2 | (INV) | 501 | 3459 | -6930 $\pm$ 115 |
| 3 | (INV) | 485 | 3084 | n.a. |
| 4 | (COMP) | 448 | 3425 | -2968 $\pm$ 159 |

As can be seen, the inventive examples exhibit very good Young's modulus and hardness properties. Furthermore, the residual stress (compressive stress) values of the (Ti,Al)N layers of the inventive examples (measured on the outer surface) is significantly higher (> 2x) than in the comparative example 4. Even though no data are indicated for the inventive example 3 ("n.a."), because a sufficiently accurate measurement could not be done due to the very small crystallite sizes of the outermost top layer (TL), the same tendency of very high residual stress (compressive stress) values could be observed for this example as well.

Cutting Tests

The coatings of examples 1 to 4 were deposited on round cutting inserts of ROHX geometry (ROHX1204M0-D67) and tested in wet milling of ISO-M workpiece material (Steel: 1.4404) applying the following cutting data:

Cutting speed ($v_c$):        120 m/min
Tooth feed ($f_z$):          0.2 mm
Number of teeth (Z)        5
Cutting depth ($a_p$):        1.5 mm

(continued)

| Cutting width (a$_e$): | variable (outer pocket) |
| Coolant: | yes |

The criterion for terminating the cutting trials was flank wear of 0.2 mm. The results of the cutting tests are given in the following table in terms of milling distance in meters.

Results of cutting tests

| Example | | Milling distance [m] |
|---|---|---|
| 1 | (INV) | 58 |
| 2 | (INV) | 60 |
| 3 | (INV) | 60 |
| 4 | (COMP) | 37 |

For the purposes of the original disclosure, it is pointed out that all features as they are apparent to a person skilled in the art from the present specification, even if they have been described specifically only in connection with certain further features, can be combined both individually and in any combination with other features or groups of features disclosed herein, unless this has been expressly excluded or technical circumstances make such combinations impossible or meaningless. The comprehensive, explicit description of all conceivable combinations of features is omitted here only for the sake of brevity and readability of the description.

While the invention has been illustrated and described in detail in the preceding description, this description is merely illustrative and is not intended to limit the scope of protection as defined by the claims. The invention is not limited to the disclosed embodiments. Variations of the disclosed embodiments are obvious to a person skilled in the art from the description and the appended claims. In the claims, the word "comprising" does not exclude other elements or steps, and the indefinite article "one" or "a" does not exclude a plurality. The mere fact that certain features are claimed in different claims does not exclude their combination.

**Claims**

1.   A method for manufacturing a coated cutting tool consisting of a substrate and a hard coating deposited thereon, the method comprising the deposition of at least a (Ti,Al)N layer onto a substrate of cemented carbide, cermet, ceramics, steel, high speed steel or cubic boron nitride by means of a High-Power Impulse Magnetron Sputtering (HIPIMS) process,

   - wherein the deposition of the (Ti,Al)N layer comprises the three steps of:

      d) deposition of a (Ti,Al)N base layer (BL) from at least one target of Ti and Al having a stoichiometric ratio of Ti:Al of from 70:30 to 33:67 at a bias voltage within the range from 20 to 60 V for a time to deposit a base layer thickness of from 0.2 $\mu$m to 0.6 $\mu$m,
      e) deposition of a (Ti,Al)N gradient layer (GL) immediately onto the base layer (BL) from at least one target of Ti and Al having a stoichiometric ratio of Ti:Al of from 70:30 to 33:67 at a gradually increasing bias voltage from 20 to 60 V at the start of the deposition of the gradient layer (GL) to 80 to 150 V at the end of the deposition of the gradient layer (GL), for a time to deposit a gradient layer thickness of from 0.4 $\mu$m to 1.8 $\mu$m,
      f) deposition of a (Ti,Al)N top layer (TL) immediately onto the gradient layer (GL) from at least one target of Ti and Al having a stoichiometric ratio of Ti:Al of from 70:30 to 20:80 at a bias voltage within the range from 80 to 150 V for a time to deposit a top layer thickness of from 0.4 $\mu$m to 1.8 $\mu$m.

   - wherein the depositions of the base layer (BL), the gradient layer (GL) and the top layer (TL) are carried out to a total thickness of the (Ti,Al)N layer of not more than 4.0 $\mu$m.

2. The method of claim 1, wherein the deposition of the gradient layer (GL) is carried out at a steadily increasing gradient of the bias voltage, preferably a linearly or step-wise increasing gradient of the bias voltage.

3. The method of anyone of the previous claims,

- wherein the deposition of the base layer (BL) is carried out at a constant bias voltage within the range from 20 to 60 V and/or
- wherein the deposition of the gradient layer (GL) starts at the bias voltage applied at the end of the deposition of the base layer (BL) and/or
- wherein the deposition of the top layer (TL) is carried out at a constant bias voltage within the range from 80 to 150 V, preferably at the bias voltage applied at the end of the deposition of the gradient layer (GL).

4. The method of anyone of the previous claims, wherein

- the depositions of the base layer (BL), the gradient layer (GL) and the top layer (TL) are carried out to a total thickness of the (Ti,Al)N layer of from 1.0 $\mu$m to 4.0 $\mu$m or from 1.2 $\mu$m to 3.5 $\mu$m or from 1.5 $\mu$m to 3.2 $\mu$m, and/or
- the deposition of the base layer (BL) is carried out for a time to deposit a base layer thickness of from 0.3 $\mu$m to 0.6 $\mu$m or from 0.4 $\mu$m to 0.5 $\mu$m, and/or
- the deposition of the gradient layer (GL) is carried out for a time to deposit a gradient layer thickness of from 0.6 $\mu$m to 1.6 $\mu$m or from 0.8 $\mu$m to 1.4 $\mu$m and/or
- the deposition of the top layer (TL) is carried out for a time to deposit a top layer thickness of from 0.6 $\mu$m to 1.6 $\mu$m or from 0.8 $\mu$m to 1.4 $\mu$m.

5. The method of anyone of the previous claims, wherein

- the deposition of the gradient layer (GL) is carried out for a time to deposit a gradient layer thickness that is at least 1.5 times the thickness of the base layer (BL) or at least 1.8 times the thickness of the base layer (BL) or at least 2.0 times the thickness of the base layer (BL).

6. The method of anyone of the previous claims, wherein

a) the deposition of the base layer (BL) is carried out at

- a sputter power within the range from 25 kW to 50 kW,
- a temperature within the range from 400°C to 500°C,
- an $N_2$ pressure within the range from 0.45 Pa to 0.70 Pa,
- an Ar pressure within the range from 0.30 to 0.80 Pa,
wherein the sputter power, the temperature, the $N_2$ pressure and/or the Ar pressure are preferably kept constant during the deposition of the (Ti,Al)N base layer (BL), and

b) the deposition of the gradient layer (GL)

- is started at the values of the sputter power, the temperature, the $N_2$ pressure and the Ar pressure within the same ranges as defined for the base layer (BL) or at the same values as applied at the end of the deposition of the base layer (BL), and
- is continued until the end of the deposition of the gradient layer (GL) at the values of the sputter power, the temperature, the $N_2$ pressure and the Ar pressure within the same ranges as defined for the base layer (BL) or at the same values as applied at the end of the deposition of the base layer (BL), or
- is continued until the end of the deposition of the gradient layer (GL)

- by gradually increasing the sputter power to 1.5 to 2.5 times of the sputter power at the start of the deposition of the gradient layer (GL), and/or
- by gradually decreasing the temperature to a temperature 30°C to 150°C or 50°C to 120°C or 60°C to 100°C below the temperature at the start of the deposition of the gradient layer (GL), and/or
- by gradually increasing the $N_2$ pressure to 1.1 to 1.5 times of the $N_2$ pressure at the start of the deposition of the gradient layer (GL), and/or

c) the deposition of the (Ti,Al)N top layer (TL) is carried out at

- the values of the sputter power, the temperature, the $N_2$ pressure and the Ar pressure within the same ranges as defined for the base layer (BL) or at the same values as applied at the end of the deposition of the gradient layer (GL),

wherein the sputter power, the temperature, the $N_2$ pressure and/or the Ar pressure are preferably kept constant during the deposition of the (Ti,Al)N top layer (TL).

7. The method of anyone of the previous claims, wherein

- the base layer (BL) is deposited immediately onto the substrate surface or
- an intermediate layer is deposited immediately onto the substrate surface prior to the deposition of the base layer (BL), and the base layer (BL) is deposited onto the intermediate layer, wherein the intermediate layer is preferably selected from TiN, TiC and TiCN and has a thickness of from 0.2 $\mu$m to 0.8 $\mu$m.

8. A coated cutting tool consisting of a substrate of cemented carbide, cermet, ceramics, steel, high speed steel or cubic boron nitride and a hard coating deposited on the substrate, wherein the coating comprises at least a (Ti,Al)N layer deposited by a High-Power Impulse Magnetron Sputtering (HIPIMS) process and having a thickness of at least 1.0 $\mu$m and not more than 4.0 $\mu$m, wherein

- the (Ti,Al)N layer comprises

a) a (Ti,Al)N base layer (BL) having a base layer thickness of from 0.2 $\mu$m to 0.6 $\mu$m,
b) a (Ti,Al)N gradient layer (GL) immediately on top of the base layer (BL) having a gradient layer thickness of from 0.4 $\mu$m to 1.8 $\mu$m,
c) a (Ti,Al)N top layer (TL) immediately on top of the gradient layer (GL) having a top layer thickness of from 0.4 $\mu$m to 1.8 $\mu$m.

- wherein each of the base layer (BL) and the gradient layer (GL) has a stoichiometric ratio of Ti:Al of from 70:30 to 33:67, and wherein the top layer (TL) has a stoichiometric ratio of Ti:Al of from 70:30 to 20:80, and
- wherein the crystallite size within the base layer (BL) of the (Ti,Al)N layer is at least three times the crystallite size within the gradient layer (GL) of the (Ti,Al)N layer, when the crystallite size is determined by XRD line profile analysis (XLPA) applying Grazing Incidence XRD (GIXRD).

9. The coated cutting tool of claim 8, wherein the crystallite size within the base layer (BL) of the (Ti,Al)N layer is at least three times, pref-erably at least four times or at least five times the crystallite size within the top layer (TL) of the (Ti,Al)N layer, when the crystallite size is determined by XRD line profile analysis (XLPA) applying Grazing Incidence XRD (GIXRD).

10. The coated cutting tool of any of claims 8 or 9, wherein the residual stress of the (Ti,Al)N layer is less than -5.000 MPa, or less than -6.000 MPa or less than -7.000 MPa (= compressive stress), when the residual stress is determined by XRD measurement and applying the $\sin^2\psi$-method using the {111}-reflection of cubic TiAlN.

11. The coated cutting tool of any of claims 8 to 10, wherein the (Ti, Al)N layer is **characterized by** a normalized peak intensity ratio

$$\left[\frac{I(1\ 1\ 1)}{I_0(1\ 1\ 1)}\right] / \left[\frac{I(2\ 0\ 0)}{I_0(2\ 0\ 0)}\right]$$

in the XRD of larger than 3, preferably larger than 4 or larger than 5, wherein

$I(1\ 1\ 1)$ and $I(2\ 0\ 0)$ = measured intensities of the $(1\ 1\ 1)$ and $(2\ 0\ 0)$ hkl-reflections in the XRD of the (Ti,Al)N layer, $I_0(1\ 1\ 1)$ and $I_0(2\ 0\ 0)$ = standard intensities of the $(1\ 1\ 1)$ and $(2\ 0\ 0)$ hkl-reflections of the standard powder diffraction data according to JCPDF-card no. 00-038-1420.

12. The coated cutting tool of any of claims 8 to 11, wherein the (Ti,Al)N layer consists of cubic phase (Ti,Al)N, determined by XRD.

13. The coated cutting tool of any of claims 8 to 12, wherein the (Ti, Al)N layer has a Vickers hardness HV0.015 $\geq$ 3200, preferably $\geq$ 3300, more preferably $\geq$ 3400.

14. The coated cutting tool of any of claims 8 to 13, wherein the (Ti, Al)N layer has a reduced Young's modulus of > 470 GPa, preferably > 480 GPa, more preferably > 490 GPa.

15. The coated cutting tool of any of claims 8 to 14, wherein the base layer (BL) of the (Ti,Al)N layer is deposited immediately on the substrate surface or on an intermediate layer deposited immediately on the substrate surface, wherein the intermediate layer is preferably selected from TiN, TiC and TiCN and has a thickness of 0.2 $\mu$m to 0.8 $\mu$m.

16. The coated cutting tool of any of claims 8 to 15, producible or produced according to the method of any of claims 1 to 7.

**EUROPEAN SEARCH REPORT**

Application Number

EP 24 16 7149

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2017/179233 A1 (SUMITOMO ELECTRIC INDUSTRIES [JP] ET AL.) 19 October 2017 (2017-10-19) | 1-16 | INV. C23C14/00 C23C14/06 |
| Y | * tables 1,2 * & JP 6 666431 B2 13 March 2020 (2020-03-13) * paragraphs [0012], [0036], [0066], [0137] * | 2 | C23C14/34 |
| Y | EP 2 298 954 A1 (SANDVIK INTELLECTUAL PROPERTY [SE]) 23 March 2011 (2011-03-23) * paragraphs [0002], [0021]; claim 1 * | 2 | |

TECHNICAL FIELDS
SEARCHED     (IPC)

C23C
H01J

The present search report has been drawn up for all claims

| Place of search | Date of completion of the search | Examiner |
|---|---|---|
| The Hague | 21 October 2024 | Schafranek, Robert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 7149

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2024

| Patent document cited in search report | Publication date | Patent family member(s) | Publication date |
|---|---|---|---|
| WO 2017179233 A1 | 19-10-2017 | JP 6666431 B2 | 13-03-2020 |
| | | JP WO2017179233 A1 | 21-02-2019 |
| | | WO 2017179233 A1 | 19-10-2017 |
| EP 2298954 A1 | 23-03-2011 | CN 102498234 A | 13-06-2012 |
| | | EP 2298954 A1 | 23-03-2011 |
| | | JP 2013505358 A | 14-02-2013 |
| | | KR 20120070569 A | 29-06-2012 |
| | | US 2011067996 A1 | 24-03-2011 |
| | | WO 2011034492 A1 | 24-03-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2023208597 A1
- WO 2013068080 A1